# EUROPEAN PATENT APPLICATION

(11) **EP 2 290 447 A1**
(43) Date of publication of application: **02.03.2011**
(21) Application number: 09168585.9
(22) Date of filing: 25.08.2009
(51) Int. Cl.: G03F 7/32, G03F 7/40, B41N 3/08

(54) **A set for developing a lithographic printing plate**

(71) Applicant: Agfa Graphics N.V., 2640 Mortsel (BE)
(72) Inventor: Hendrikx, Peter, 2640, Mortsel (BE); Williamson, Alexander, 2640, Mortsel (BE); Sinnesael, Jan, 2640, Mortsel (BE); Carbonini, Roberto, 25025 Manerbio (BS) (IT)

(57) **Abstract**

A set comprising an aqueous clean-out solution and an aqueous preservation solution, said set being suitable for developing a lithographic printing plate precursor, both said solutions having a pH between 2 and 10, **characterized in that** the clean-out solution has an aggressiveness towards an image area of said developed precursor as defined in the description of three or more, while the preservation solution has such an aggressiveness of less than three.

## Description

### FIELD OF THE INVENTION

The present invention relates to a set of an aqueous clean-out solution and an aqueous preservation solution, said set being suitable for processing a printing plate precursor, to a method of preparing a printing plate using said set of solutions and to an apparatus in which said set of solutions is used to prepare a photopolymer printing plate.

### BACKGROUND OF THE INVENTION

In lithographic printing, a so-called printing master such as a printing plate is mounted on a cylinder of the printing press. The master carries a lithographic image on its surface and a printed copy is obtained by applying ink to said image and then transferring the ink from the master onto a receiver material, typically paper. In conventional, so-called "wet" lithographic printing, ink as well as an aqueous fountain solution (also called dampening liquid) are supplied to the lithographic image consisting of oleophilic (or hydrophobic, i.e. ink-accepting, water-repelling) areas as well as hydrophilic (or oleophobic, i.e. water-accepting, ink-repelling) areas. In so-called "driographic" printing, the lithographic image consists of ink-accepting and ink-abhesive (ink-repelling) areas and during driographic printing only ink is supplied to the master.

The so-called "analogue" printing plates are generally obtained by first applying a so-called computer-to-film (CtF) method, wherein various pre-press steps such as typeface selection, scanning, color separation, screening, trapping, layout and imposition are accomplished digitally and each color selection is transferred to graphic arts film using an image-setter. After processing, the film can be used as a mask for the exposure of an imaging material called plate precursor and after plate processing, a printing plate is obtained which can be used as a master. Since about 1995, the so-called "computer-to-plate" (CtP) method has gained a lot of interest. This method, also called "direct-to-plate", bypasses the creation of film because the digital document is transferred directly to a printing plate precursor by means of a platesetter. A printing plate precursor for CtP is often called a digital plate.

Digital plates can roughly be divided in three categories:
(i) silver plates, working according to the silver salt diffusion transfer mechanism; (ii) photopolymer plates containing a photopolymerizable composition that hardens upon exposure to light and (iii) thermal plates of which the imaging mechanism is triggered by heat or by light-to-heat conversion.

Photopolymer plate precursors can be sensitized for blue, green or red light (i.e. wavelength range between 450 and 750 nm), for violet light (i.e. wavelength range between 350 and 450 nm) or for infrared light (i.e. wavelength range between 750 and 1500 nm). Lasers have become the predominant light source used to expose photopolymer printing plate precursors. Typically, an Ar laser (488 nm) or a FD-YAG laser (532 nm) can be used for exposing a visible light sensitized photopolymer plate precursor. The wide-scale availability of low cost blue or violet laser diodes, originally developed for data storage by means of DVD, has enabled the production of platesetters operating at shorter wavelengths. More specifically, semiconductor lasers emitting from 350 to 450 nm have been realized using an InGaN material. For this reason, photopolymer plates having their maximal sensitivity in the 350 nm to 450 nm region have been developed during the last years. An advantage of violet photopolymer technology is the reliability of the laser source and the possibility of handling the non-developed photopolymer plate precursors in yellow safelight conditions. The use of infrared lasers also became more important in the last years, for example the Nd-YAG laser emitting around 1060 nm but especially the infrared laser diode emitting around 830 nm. For these laser sources, infrared sensitive photopolymer plate precursors have been developed. A major advantage of infrared photopolymer technology may be the possibility to handle the non-developed photopolymer plate precursors in daylight conditions.

After exposure of a photopolymer plate precursor a rather complex processing is typically carried out. A pre-heat step is usually carried out to enhance the polymerization and/or crosslinking in the imaged areas. Then during a pre-wash step, typically with plain water, the protective layer or overcoat of the photopolymer plate precursor is removed. After the pre-wash step the non-imaged parts are removed in a development step, typically with an alkaline developer having a
pH > 10. After the development step, a rinse step, typically with plain water, and a gumming step is carried out. Gumming protects the printing plate during the time between development and printing against contamination for example by oxidation, fingerprints, fats, oil or dust, or against damage, for example during handling of the plate. Such processing of photopolymer plates is usually carried out in automatic processors having a pre-heat section, a pre-wash section, a development section, a rinse and gum section and a drying section.

To avoid this complex, time consuming and environmentally unfriendly processing of photopolymer plate precursors several alternatives have been described.

In US6027857, US6171735, US6420089, US6071675, US6245481, US6387595, US6482571, US6576401 and US6548222 a method is disclosed for preparing a lithographic printing plate wherein a photopolymer plate precursor, after image-wise exposure, is mounted on a press and processed on-press by applying ink and fountain to remove the unexposed areas from the support. Also US2003/16577 and US2004/13968 disclose a method wherein a plate precursor comprising a photopolymerizable layer can be processed on-press with fountain and ink or with a non-alkaline aqueous developer.

In WO2005/111727 a method is disclosed wherein a photopolymer plate precursor is developed by applying a gum solution to the plate. The gum solution, for example a gum solution used in the gumming step of the conventional processing method, is used for both developing, i.e. removal of the non-imaged parts of the coating, and gumming of the exposed and developed photopolymer plates. So, according to this method, no pre-wash step, no rinse step and no additional gum step is needed anymore during processing. This method provides a simplified processing of photopolymer plate precursors and in addition, since on the one hand no highly alkaline developer is used anymore and on the other hand much less processing liquids are used altogether (no pre-wash, no rinse and no separate gum), provides an environmentally more friendly processing. Other methods, all using a gum solution to develop photopolymer plates, are disclosed in for example WO2007/057335 and W02007/057349. Also, EP-As 1621339, 1630618, 1708033, 1748317, 1755002 disclose a plate making method wherein an aqueous solution having a pH between 2 and 10 is used to develop the exposed photopolymer printing plate precursor.

WO2007/057334 discloses a method of preparing a photopolymer plate with a gum solution as developer wherein a prewash is carried out to at least partly remove the overcoat of the precursor. WO2007/057335 and WO2007/057349 disclose a method of preparing a photopolymer plate wherein the exposed precursor is developed in a first and a second gumming unit with a gum solution. Using two gumming solutions in two different gumming units has the advantage that sludge formation in the second gumming unit is retarded or inhibited.

EP-A 2048000 discloses a method of preparing a printing plate precursor wherein an exposed precursor is consecutively processed in a first gum solution, water and a second gum solution. Preferably both gum solutions are identical. With such a three bath configuration, redeposition of coating residues on the plate is avoided.

Such a development with a gum solution or an aqueous solution having a pH between 2 and 10 is often referred to as a non-alkaline or mildly alkaline development in contrast to the highly alkaline conventional processing of photopolymer plates.

A problem however associated with the manufacture of printing plates with such a non-alkaline or mildly alkaline aqueous solution as developer may be an insufficient clean-out of the obtained printing plates. An insufficient clean-out means an insufficient removal of the non-imaged areas, which may result in stain or toning on the printed image. Even when a good clean-out is obtained with a fresh developer, it has been observed that the clean-out may become insufficient upon development of a number of precursors with the same solution, i.e. upon extended use or even exhaustion of the solution.

An improvement of the clean-out may be obtained by adjusting the composition of the aqueous solution. For example when a more aggressive clean-out solution is used wherein the coating composition of the precursor becomes more soluble or dispersible, an improved clean-out may be expected. However, it has been observed that when such an aqueous solution remains on the image areas of the developed plate, for example as drops or streaks, those image areas may be deteriorated by the aqueous solution upon storage of the plate, resulting in for example a dot loss of screened image areas on the press-ready plate. Such a dot loss means a decrease of the dot coverage, i.e. the dots become smaller.

It is thus difficult to provide a single aqueous solution having a pH between 2 and 10 as developer for a printing plate precursor, which results in a good clean-out, even after several precursors have been developed in the solution, and which does not adversely affect the properties of the plates upon storage.

### SUMMARY OF THE INVENTION

It is a first object of the present invention to provide a set of two aqueous solutions suitable for developing a lithographic printing plate precursor, with which a high number of printing plates can be prepared having a sufficient clean-out and good storage properties.

It is a second object of the present invention to provide a set of a lithographic printing plate precursor and two aqueous solutions suitable for developing said lithographic printing plate precursor, with which a high number of printing plates can be prepared having a sufficient clean-out and good storage properties.

It is a third and a fourth object of the present invention to provide a method of preparing a lithographic printing plate using the sets of the first and second object of invention.

It is a fifth object of the present invention to provide a processing unit especially adapted to carry out such method of preparing a lithographic printing plate.

Preferred embodiments of the invention are defined in the dependent claims.

### BRIEF DESCRIPTION OF THE DRAWINGS

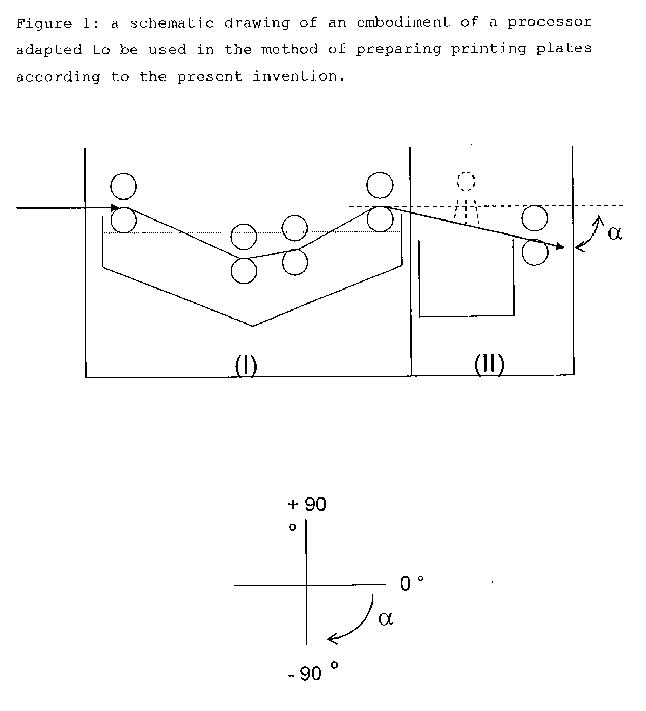

Figure 1 is a schematic drawing of an embodiment of a processor adapted to be used in the method of preparing printing plates according to the present invention.

### DETAILED DESCRIPTION OF THE INVENTION

Set of developing liquids

The set comprises an aqueous clean-out solution and an aqueous preservation solution, said set being suitable for developing a lithographic printing plate precursor. Both said solutions have a pH between 2 and 10, preferably between 4 and 9, more preferably between 5 and 8.5, most preferably between 6 and 8.

The aqueous solutions may be supplied as a ready-to-use or as a concentrated solution, the latter of which is diluted by the end user with water to a ready-to-use solution according to the instructions of the supplier: typically 1 part of the concentrated solution is diluted with 1 to 10 parts of water. The pH values disclosed above refer to the ready-to-use solution.

The aqueous solutions typically comprise a surfactant and a water soluble polymer. In addition, they may further comprise a wetting agent, an antiseptic agent, a chelating compound, a defoaming compound, an organic and/or inorganic acid, an organic solvent, an inorganic salt. Preferred ingredients which can be used in the aqueous solutions are disclosed in WO2005/111727 (page 6, line 5 to page 11, line 35) and EP-A 1621339 (paragraphs [0014] to [0061]).

The surfactants may be cationic, anionic, amphoteric or non-ionic, examples of which are disclosed in EP-A 2048000, paragraphs [0026] to [0030]. Anionic or non-ionic surfactants are preferred. Highly preferred surfactants are block copolymers based on ethylene oxide and propylene oxide such as the commercially available Pluronic® surfactants such as Pluronic 9400. Other preferred surfactants are tristyrylphenol ethoxylates such as the Emulsogen® surfactants, for example Emulsogen TS160 or TS200. Highly preferred, a combination of both these surfactants is used.

The preservation solution comprises a surface protective compound, also referred to as oil-desensitizing agents, as disclosed in EP-A 2048000, paragraphs [0020] to [0023]. However, the clean-out solution may also comprise such a surface protective compound.

The clean-out solution preferably comprises a salt formed by reaction of an acid, containing a phosphorous atom, with a di- or tri-alkanolamine as disclosed in W02008/138942.

The set of aqueous solutions described above is used in such a way that the processing or development of an exposed precursor is carried out by first applying the clean-out solution and then the preservation solution to the precursor. During processing or development, the clean-out solution is used to remove an optional overcoat and unexposed areas of the image-recording layer of the exposed precursor. The composition of the clean-out solution determines the clean-out of the obtained printing plate. In order to obtain a sufficient clean-out, even after processing several precursors with the same solution, the composition of the clean-out solution is such that unexposed areas of the image-recording layer are readily solubilized or dispersed in it. As a consequence however, exposed areas or image areas are necessarily also deteriorated by such a clean-out solution. The latter effect is referred to as aggressiveness of the clean-out solution towards image areas of a developed precursor and may result in dot loss in those image areas.

The aggressiveness of the clean-out solution towards an image area of a developed precursor may be optimized by changing the pH, the nature and amount of surfactant or by adding a low molecular organic compound, which can act as solvent for an ingredient of the image-recording layer. The optimal composition will however also depend on the composition of the image-recording layer of the precursor for which they are used. For that reason, a test method is defined to identify the aggressiveness of the clean-out solution towards image areas of a developed precursor.

A test image having a 40 % dot coverage is exposed on the precursor with a platesetter. The exposure density level used is the exposure density level recommended by the supplier of the precursor to image the precursor with that platesetter. The exposure resolution used is 1270 dpi and the screening frequency 110 lpi. When this exposure resolution and/or screening frequency is not available, an alternative exposure resolution and/or screening frequency is used, which is as close as possible to the values indicated.

After exposure a pre-heat treatment is performed as recommended by the supplyer of the precursor. For example in the pre-heat unit of an Agfa Graphics VSP85 processor using a plate speed of 1.2 m/min and a plate temperature (measured on the backside of the exposed precursor) of 110°C.

After the pre-heat treatment, the precursor is developed in a processing unit as recommended by the supplyer with the clean-out solution. For example in a processing unit comprising two brush rollers, filled with the clean-out solution at room temperature (20°C - 25°C), wherein the time difference between entrance of the precursor in the aqueous solution (dipping) and the first brush contact is 11 seconds and the total dwell time of the precursor in the aqueous solution amounts to 36 seconds.

The resulting press-ready printing plate is subsequently left to dry at room temperature.

Several drops (10 µl) of the clean-out solution are then applied to the test image (with a 40% (@ 1101pi) dot coverage) on the dry press-ready printing plate and are left there during 30 minutes and subsequently wiped away with a wet cotton pad.

The aggressiveness of the clean-out solution towards an image area of the developed precursor is evaluated using the following evaluation scale:
1 = a dot coverage shift of 0 to 2 %
2 = a dot coverage shift of 2 to 4 %
3 = a dot coverage shift of 4 to 9 %
4 = a dot coverage shift of 9 to 24 %
5 = a dot coverage shift of 24 to 100 % (= total loss)

The dot coverage shift (reference is a 40 % test image whereupon no drops of the clean-out solution were applied) is measured with a GretagMacBeth D19C densitomer (automatic filter setting) (commercially available from GretagMacbeth).

The aggressiveness of the clean-out solution towards the image areas of a developed precursor measured as defined above must be at least 3, preferably at least 4, more preferably at least 5.

It has been found that when the aggressiveness of the clean-out solution in the set of developing solutions is at least 3, a good clean-out of the exposed precursor is obtained, even after development of a high number of plates. A good clean-out means that the non-image areas have an optical density of not greater than 0.15 (measured with a GretagMacBeth D19C densitometer (automatic filter setting) and wherein the densitometer is zeroed on the non-image area of the plate after processing with a typical highly alkaline developer, for example with PL10 developer from Agfa Graphics at a temperature of 24°C with a processing speed of 1.2 m/min. in the development section of a VSP85 processor from Agfa Graphics).

It is clear that when using an aggressive clean-out solution as defined above as a single developing solution, drops of that clean-out solution remaining on the developed plate, may cause problems during storage of the plate as the clean-out solution may deteriorate the image areas.

It has been now been found that when a second, less aggressive aqueous solution, referred to herein as preservation solution, is applied to a precursor developed in the above clean-out solution, the storage properties of the obtained plates become sufficient. Between developing the precursor with the clean-out solution and applying the preservation solution, it is not necessary to wash the plate with water or another aqueous solution, which is an advantage with regard to the footprint of the processor that is used and to the total consumption level of processing liquids.

The aggressiveness of the preservation solution measured as described above but by applying drops of the preservation solution on the exposed and developed precursor instead of drops of the clean-out solution, is less than 3, preferably less than 2, more preferably less than 1.

### Method of preparing a lithographic printing plate precursor

In the method of preparing a lithographic printing plate precursor according to the present invention, a set of processing liquids described above are used to develop an exposed precursor. After exposing and optionally pre-heating the precursor, the precursor is developed by first applying the clean-out solution and then the preservation solution.

Development is preferably carried out in an automatic processor using spray or dip development. Spray development involves spraying a developing solution on the plate precursor, for example with one or more spray bars. Dip development involves immersion of the plate into a developing solution. Another preferred manner of applying the developing solution to the precursor is by roller coating in which the developing solution is applied to a guidance roller of a processor which then transfers the solution to the precursor. Such roller coating is commonly used in the gumming section of automatic processors used for conventional (highly alkaline) processing of photopolymer plates.

In a preferred embodiment, development with the clean-out solution is a dip development, while the preservation solution is applied by spraying or roller coating, most preferably by roller coating.

In a preferred embodiment, the development is a batch development, i.e. development is carried out with a batch of developer until development is no longer sufficient. At that moment a new batch of developer is introduced in the processor. However, development may also be carried out with regeneration of the developer, whereby a given amount of fresh developer is added to the development solution as function of the number of plates already developed. The composition and/or concentration of the fresh developer added during regeneration may be the same or different to that of the initial developer. In another preferred embodiment the clean-out solution is regenerated continuously, while the preservation solution is not (batch development).

The first developing step with the clean-out solution may be combined with mechanical rubbing, preferably by one or more rotating brushes, to better remove the non-imaged parts of the image-recording layer. Preferred rotating brushes are described in US2007/0184387 (paragraphs [0255] to [0257]) and EP-A 1 755 002 (paragraphs [0025] to [0034]). Good results may also be obtained with "flat" brushes. These "flat" brushes may have a width of for example 5.0 to 10 cm and may be equipped with polypropylene or nylon bristles. The length of the bristles may be from 5 to 15 mm. Typically, these "flat" brushes are rubbing the plate precursor by moving back and forth in a direction perpendicular to the plate conveying direction through the processor. Rubbing may be realized by up to 120 movements per minute.

In the development step with the clean-out solution, an optional overcoat and an image area of the image recording layer is removed.

### Processor

A processor used in the method of preparing a printing plate using the set of processing liquids as defined above typically has a section wherein the clean-out solution is applied to the precursor, the clean-out section (I), and a section wherein the preservation solution is applied, the preservation section (II).

A possible drawback of the method of preparing a printing plate precursor with the set of processing liquids as described above is the so-called "runback" of the preservation solution into the section of the processor containing the clean-out solution. Such a "runback" may have the result that the aggressiveness of the clean-out solution decreases, resulting in a worsening of the clean-out of the non-image areas of the press-ready plate.

Figure 1 shows a schematic presentation of a processor unit adapted to be used in the method of preparing a printing plate according to the present invention. In Figure 1 only the clean-out section (I) and the preservation section (II) are depicted. Other sections typically present in an automatic processor such as a pre-heat section and a drying section are not shown.

"Runback" is prevented by a processor unit comprising a clean-out section (I) and a preservation section (II) **characterized in that** a section of the plate whereupon the preservation solution is applied is conveyed through the preservation section under an angle α with respect to a horizontal direction of less than 0 and greater than or equal to minus 45 degrees, preferably minus 30 degrees, more preferably minus 10 degrees, most preferably minus 5 degrees.

The processor may also comprise a pre-heating unit positioned before the clean-out section and a drying section positioned after the preservation unit. When a pre-heating unit is present and operational, cooling means may also be present as disclosed in the unpublished EP-A 08102922.5 (filed 2008-03-26).

### Printing plate precursor

Any printing plate precursor capable of being developed with an aqueous solution having a pH between 2 and 10 solution may be used in the present invention. Preferably a photopolymer printing plate precursor is used. The photopolymer printing plate precursors may be sensitive to ultraviolet light, visible light and/or infrared light. Preferably, they are sensitized for (ultra)violet light, i.e. for light having a wavelength ranging from 350 nm to 450 nm, more particulary for the violet wavelength range from 390 to 420 nm, or for infrared light, i.e. light having a wavelength ranging from 750 nm to 1500 nm.

A typical photopolymer printing plate precursor typically comprises a photopolymerizable coating provided on a hydrophilic support.

The support is preferably a grained and anodized aluminum support, well known in the art. Suitable supports are for example disclosed in EP-A 1843203 (paragraphs [0066] to [0075]). The grained and anodized aluminum support may be subjected to so-called post-anodic treatments, for example a treatment with polyvinylphosphonic acid or derivatives thereof, a treatment with polyacrylic acid, a treatment with potassium fluorozirconate or a phosphate, a treatment with an alkali metal silicate, or combinations thereof. Besides an aluminum support, a plastic support, for example a polyester support, provided with one or more hydrophilic layers may also be used.

The coating provided on the hydrophilic support comprises a photopolymerizable layer, also referred to as the image-recording layer. The coating may further comprise an overcoat and/or an undercoat, the latter also referred to as an intermediate layer or an interlayer.

The optional overcoat, provided on the photopolymerizable or image-recording layer, also referred to as toplayer or protective layer, acts as an oxygen barrier layer. Preferred binders which can be used in the top layer are disclosed in WO2005/029190 (page 36 line 3 to page 39 line 25), US 2007/0020563 (paragraph [0158]) and EP 1 288 720 (paragraphs [0148] and [0149]). The most preferred binders for the overcoat are polyvinylalcohol and polyvinylpyrrolidone.

The photopolymerizable layer or image-recording layer typically comprises at least one polymerizable monomer or oligomer, at least one polymeric binder, a photo-initiator and a sensitizer. The photo-initiator - sensitizer system is choosen as function of the exposure wavelength. The photopolymerizable layer may further comprise a contrast dye or pigment, an polymerization inhibitor, a chain transfer agent, adhesion promoting agents interacting with the aluminum surface and other ingredients which may further optimize the properties of the printing plate precursors.

The coating may also comprise one or more intermediate layers, provided between the photopolymerizable image-recording layer and the support. Such an intermediate layer may further optimize the interaction between the image-recording layer and the support, i.e. enable the complete removal of non-imaged parts and a sufficient adhesion of the imaged parts of the image-recording layer.

Preferred violet sensitive printing plate precursors are disclosed in WO2005/111727, WO2005/029187, WO2007/113083, WO2007/057333, WO2007/057442, W02008/145528, W02008/145529 and W02008/145530. Other violet sensitive printing plate precursors that may be used in the method of the present invention are those disclosed in EP-A 1 793 275, US2007/0184387 and EP-A 1 882 585.

Besides the preferred sensitizers disclosed in WO2008/145528, WO2008/145529 and W02008/145530, it has been found that sensitizers according to Formula I also have an improved crystallization behaviour in a typical coating (solution) of a violet sensitive photopolymer precursor. 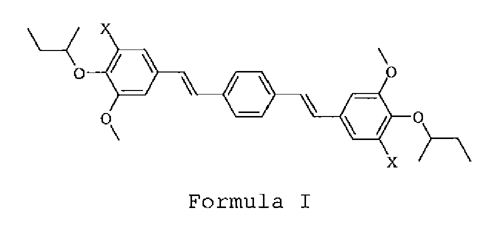 wherein X is Br or I.

Preferred IR sensitive printing plate precursors are disclosed in WO2005/111727, EP-As 1788448 and 1788449 and W02009/063024. Other IR sensitive printing plate precursors that may be used in the method of the present invention are those disclosed in EP-As 1602982, 1621339, 1630618 and 1695822.

Preferred IR and violet sensitive printing plate precursors are also disclosed in the unpublished EP-A 081677404.6 (filed 2008-10-23).

### EXAMPLES

### MATERIALS

All materials used in the examples were readily available from standard sources such as Aldrich Chemical Co. (Belgium) and Acros (Belgium) unless otherwise specified.
- PVA-1: partially hydrolyzed poly(vinyl alcohol); degree of saponification is 88 mol %; viscosity of a 4 wt % aqueous solution at 20 °C is 4 mPa•s; available as MOWIOL 4/88 from Kururay.
- PVA-2: partially hydrolyzed poly(vinyl alcohol); degree of saponification is 98 mol %; viscosity of an aqueous solution of 4 wt % at 20 °C is 4 mPa•s; available as MOWIOL 4/98 from Kururay.
- Acticide: Acticide LA 1206, a biocide commercially available from Thor Overseas.
- Lutensol: A 90 wt % solution in water of Lutensol A8, a surface active agent commercially available from BASF.
- Advantage S: a vinylpyrrolidone-vinylcaprolactam-dimethylaminoethyl methacrylate copolymer commercially available from ISP.
- Edaplan: a 10 wt % solution in Dowanol PM of Edaplan LA411, a modified siloxane-glycol copolymer commercially available from Munzing Chemie.
- FST426R: a solution in MEK containing 88.2 wt % of a reaction product from 1 mole of 2,2,4-trimethyl-hexamethylenediisocyanate and 2 moles of hydroxyethylmethacrylate (kinematic viscosity 3.30 mm²/s at 25 °C).
- Mono Z1620: a solution in MEK containing 30.1 wt % of a reaction product from 1 mole of hexamethylene-diisocyanate, 1 mole of 2-hydroxyethylmethacrylate and 0.5 mole of 2-(2-hydroxyethyl-piperidine (kinematic viscosity 1.7 mm²/s at 25 °C).
- Heliogene Blue: dispersion in Dowanol PM/MEK/γ-butyrolactone containing 5 wt % of Heliogen blau D7490 pigment and 2.5 wt % of KL7177 and 2.5 wt % KOMA30 NEU as dispersants. Heliogen blau D7490 is commercially available from BASF.
- Hostanox: a 10 wt % solution in Dowanol PM of Hostanox 03,a phenolic antioxidant commercially available from CLARIANT.
- HABI: 2-(2-chlorophenyl)-4,5-diphenyl bisimidazole, commercially available from SUMITOMO.
- MBT: 2-mercaptobenzthiazole.
- Sensitizer: a violet sensitizer mixture consisting of the following compounds: 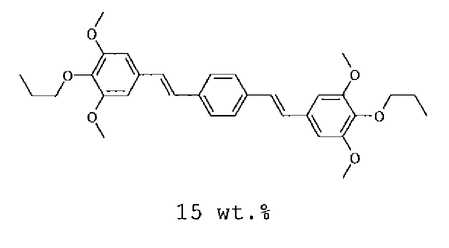 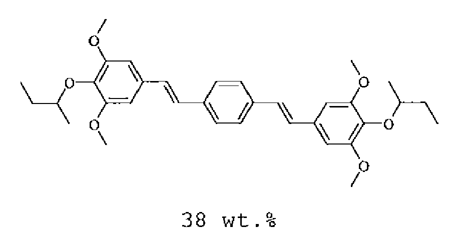 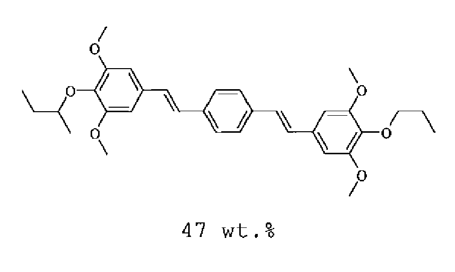
- Avedex: Avedex 37 LAC 19, a potato dextrine commercially available from AVEBE.
- Texapon 842; a 42 wt % solution of sodium octylsulphate in water, commercially available from COGNIS.
- Emulsogen TS160: a 25 wt % solution in demineralized water of Emulsogen TS160, a 2,4,6-tris-(1-phenylethyl)-polyglycolether having approximately 15 ethyleneoxyde units commercially available from CLARIANT.
- Dowanol PM: 1-methoxy-2-propanol, commercially available from DOW CHEMICAL COMPANY.
- Dowanol PPH: phenoxypropanol, commercially available from DOW CHEMICAL COMPANY.
- MEK: methylethylketone or 2-butanone.
- Triethanolamine: a 80 wt % solution in water of triethanolamine, commercially available from BASF.
- Phosphoric acid: a 85 wt % solution of phosphoric acid in water.
- Dowfax 3B2: commercially available from DOW CHEMICAL COMPANY.
- Disodium salt of 1,3-benzenedisulphonic acid, commercially available from RIEDEL-DE-HAEN.
- Versa TL77: a 30 wt % solution in demineralized water of sulphonated polystyrene, commercially available from ALCO CHEMICAL.
- Trisodium citrate dihydrate: commercially available from JUNGBUNZLAUER.
- Proxel Ultra 5: a 5 wt % solution in water of the biocide Proxel Ultra 5, commercially available from AVECIA.
- KOMA30 NEU, copolymer consisting of 64 mol% vinyl butyral - 26 mol% vinyl alcohol - 2 mol% vinyl acetate - 8 mol% esterification product of vinylalcohol and trimellitic acid anhydride, commercially available from CLARIANT.
- KL7177, methacrylic acid - metylmethacrylate copolymer, commercially available from CLARIANT.

### Support

A 0.3 mm thick aluminum foil was degreased by spraying with an aqueous solution containing 26 g/l NaOH at 65°C for 2 seconds and rinsed with demineralised water for 1.5 seconds. The foil was then electrochemically grained during 10 seconds using an alternating current in an aqueous solution containing 15g/l HCl, 15g/l SO4²⁻ ions and 5g/l Al³⁺ ions at a temperature of 37°C and a current density of about 100 A/dm². Afterwards, the aluminum foil was desmutted by etching with an aqueous solution containing 5.5 g/l NaOH at 36°C for 2 seconds and rinsed with demineralised water for 2 seconds. The foil was subsequently subjected to anodic oxidation during 15 seconds in an aqueous solution containing 145 g/l of sulfuric acid at a temperature of 50°C and a current density of 17 A/dm², then washed with demineralised water for 11 seconds and post-treated for 3 seconds (by spray) with a solution containing 2.2 g/l PVPA at 70°C, rinsed with demineralised water for 1 seconds and dried at 120°C for 5 seconds.

The support thus obtained was characterised by a surface roughness Ra of 0.35-0.4 µm (measured with interferometer NT1100) and had an anodic weight of 3.0 g/m².

### Photo layer

The composition of the coating solution for the photo layer PL is given in Table 1. The wet coating thickness was 20 µm. After drying for 1 minute at 120°C in a circulation oven, a dry coating weight of 1.2 g/m² was obtained. The dry coating weight of each component (in mg/m²) is given in Table 2.

**Table 1**

| Ingredients PL coating solution | (g) |
|---|---|
| Edaplan | 0.567 |
| MEK | 212.208 |
| Sensitizer | 2.433 |
| Dowanol PM | 543.658 |
| FST426R | 7.333 |
| Mono Z1620 | 77.608 |
| Heliogene Blue | 45.333 |
| Hostanox | 0.283 |
| HABI | 3.683 |
| MBT | 0.167 |
| KOMA 30 NEU | 106.722 |

**Table 2**

| Dry coating weight PL | (mg/m²) |
|---|---|
| Edaplan | 1.2 |
| Sensitizer | 52.2 |
| FST426R | 138.6 |
| Mono Z1620 | 499.0 |
| Heliogene Blue | 97.2 |
| Hostanox | 0.6 |
| HABI | 78.9 |
| MBT | 3.6 |
| KOMA 30 NEU | 343.1 |
| Total | 1214.4 |

### Overcoat layer

The overcoat (OC) layer (or top layer) was applied from an aqueous solution. The composition of the coating solution is given in table 3. The wet coating thickness was 39.2 µm. After drying at 110°C for 2 minutes a dry coating weight of 1.25 g/m² was obtained. The dry coating weight of each component (in mg/m²) is given in Table 4.

**Table 3**

| Ingredients OC coating solution | (g) |
|---|---|
| PVA-1 | 19.128 |
| PVA-2 | 11.532 |
| Acticide | 0.053 |
| Advantage S | 0.633 |
| Lutensol | 0.335 |
| Water | 968.319 |

**Table 4**

| Dry coating weight OC | (mg/m²) |
|---|---|
| PVA-1 | 756.6 |
| PVA-2 | 456.1 |
| Acticide LA 1206 | 2.1 |
| Advantage S | 25.0 |
| Lutensol A8 | 11.9 |
| Total | 1251.7 |

### Printing Plate Precursor PPP-01

The photo layer PL was coated on the aluminum substrate described above. On top of the photo layer PL, the above described overcoat layer OC was applied. This resulted in printing plate precursor PPP-01.

Imaging and Processing of Printing Plate Precursor PPP-01

### Exposure

Exposure was carried out on an Agfa Advantage DL3850 violet platesetter (commercially available from Agfa Graphics). Several printing plate precursor plates were exposed at an exposure density level of 37.6 µJ/cm². The exposure resolution was 1270 dpi and the screening used was 100 lpi Agfa Balanced Screening (commercially available from Agfa Graphics).

### Pre-heat

After exposure a pre-heat treatment was performed in the pre-heat section of a VSP85 processor, commercially available from Agfa Graphics (plate speed = 1.2 m/min ; plate temperature (measured on the backside of the printing plate precursor) = 110°C).

### Development

After pre-heat, the plate precursors were developed in a gumming unit, comprising one brush roller, filled with either the clean-out solution A or the preservation solution B at room temperature (20°C - 25°C). The time difference between entrance of the precursor in the aqueous solution (dipping) and brush contact is 11 seconds and the total dwell time of the precursor in the gum solution amounts to 36 seconds. Where two solutions were consecutively used to develop the precursor, after development with one solution in a first gumming unit, the precursor was entered in a second gumming unit filled with the other solution.

The clean-out solution A was prepared by adding to 650 ml of demineralized water the ingredients listed in Table 5.

**Table 5**

| Ingredients of clean-out solution A | |
|---|---|
| Avedex | 25 g |
| Emulsogen TS160 | 67 ml |
| Dowanol PPH | 9.5 ml |
| Texapon 842 | 21.2 ml |
| Phosphoric acid | 3.01 g |
| Triethanolamine | 7.0 g |

Subsequently, demineralized water was added up to a total volume of 1 liter and then the pH was adjusted to 7.00 (+ 0.1/-0.05) (@ 25°C) by adding triethanolamine.

The preservation solution B was prepared by adding to 650 ml of demineralized water the ingredients listed in Table 6.

**Table 6**

| Ingredients of preservation solution B | |
|---|---|
| Avedex | 25 g |
| Dowfax 3B2 | 44 ml |
| Disodium salt of 1,3-benzenedisulphonic Acid | 15.63 g |
| VERSA TL77 | 15.63 ml |
| Trisodium citrate dihydrate | 5.20 g |
| Proxel Ultra 5 | 7.0 g |

Subsequently, demineralized water was added up to a total volume of 1 liter. The final pH (@ 25°C) was 7.3 ± 0.2.

The resulting press-ready printing plates were subsequently left to dry at room temperature.

### Clean-out

In Table 7 the clean-out (optical density of the non-image areas) of the resulting printing plates is given as function of the solution(s) used to develop the printing plate precursors.

**Table 7**

| | first solution | second solution | clean-out* |
|---|---|---|---|
| COMP | solution A | - | 0.06 |
| COMP | solution A | solution A | 0.05 |
| INV | solution A | solution B | 0.06 |
| COMP | solution B | - | 0.31 |
| COMP | solution B | solution B | 0.30 |
| COMP | solution B | solution A | 0.27 |

| | | | |
|---|---|---|---|
| *: measured with a GretagMacBeth D19C densitomer (cyan filter setting) zeroed on the non-image areas of a plate developed with PL10 developer from Agfa Graphics at a temperature of 24°C and with a processing speed of 1.2 m/min. in the development section of a VSP85 processor from Agfa Graphics. | | | |

From the results given in Table 7 it is clear that only with the clean-out solution A, when used alone or prior to the preservation solution B, a good clean-out (optical density of the non-image areas lower than or equal to 0.15) is obtained.

### Aggressiveness test

An exposed plate precursor was developed with the clean-out solution A as described above. Several drops (10 µl) of either solution A or solution B were applied to a test image with a 40% (@ 1101pi) coverage on the dry press-ready printing plate and were left there during different periods of time ranging from 5 minutes up to 2 hours and subsequently wiped away with a wet cotton pad.

The resistance of the coating vis-à-vis the solutions used is then evaluated using the following evaluation scale:
1 = a dot coverage shift of 0 to 2%
2 = a dot coverage shift of 2 to 4%
3 = a dot coverage shift of 4 to 9%
4 = a dot coverage shift of 9 to 24%
5 = a dot coverage shift of 24 to 100% (= total loss)

The dot coverage shift ((reference is a 40 % test image whereupon no drops of either solution A or B were applied) was measured with a GretagMacBeth D19C densitomer (cyan filter setting) (commercially available from GretagMacbeth).

In table 8 the aggressiveness of the clean-out solution A and the preservation solution B towards the image areas of a developed plate (developed in the clean-out solution A) is shown as function of the storage time.

**Table 8**

| Solution | Aggressiveness | | | | | |
|---|---|---|---|---|---|---|
| | 5' | 10' | 15' | 30' | 60' | 120' |
| Clean-out solution A | 1 | 2 | 3 | 3 | 4 | 5 |
| Preservation solution B | 1 | 1 | 1 | 1 | 1 | 1 |

The aggressiveness test is carried out on a plate obtained by development of the precursor in the clean-out solution A as such a plate has a sufficient good clean-out.

From Table 8 it is clear that clean-out solution A is aggressive towards image areas of the plate (aggressiveness 3 after 30 minutes of contact) while the preservation solution B is not aggressive at all (aggressiveness of 1 after 30 minutes of contact).

It has indeed been found that when development is carried out with the clean-out solution A alone, drops of streaks of the clean-out solution A still present on the obtained plate gave rise to deterioration of the image areas where those drops or streaks were present during storage. However, when both the clean-out solution A and the preservation solution B, in that order, are used to develop the precursor, no problems were encountered after storage.

## Claims

1. A set comprising an aqueous clean-out solution and an aqueous preservation solution, said set being suitable for developing a lithographic printing plate precursor, both said solutions having a pH between 2 and 10, **characterized in that** the clean-out solution has an aggressiveness towards an image area of said developed precursor as defined in the description of three or more, while the preservation solution has such an aggressiveness of less than three.

2. A set comprising a lithographic printing plate precursor, an aqueous clean-out solution and an aqueous preservation solution, said solutions together being suitable for developing said lithographic printing plate precursor, both said solutions having a pH between 2 and 10, **characterized in that** the clean-out solution has an aggressiveness towards an image area of said developed precursor as defined in the description of three or more, while the preservation solution has such an aggressiveness of less than three.

3. A set according to claim 1 comprising no other solutions than the clean-out and the preservation solution.

4. A set according to claim 2 comprising no other solutions than the clean-out and the preservation solution.

5. A set according to any of the preceding claims wherein the precursor is a photopolymer printing plate precursor.

6. A method of preparing a lithographic printing plate using a set as defined in claim 1 or 3 comprising the steps of:
- providing a printing plate precursor,
- exposing the precursor,
- optionally pre-heating the exposed precursor,
- developing the exposed precursor by applying first the clean-out solution and then the preservation solution.

7. A method of preparing a lithographic printing plate using a set as defined in claim 2 or 4 comprising the steps of:
- exposing the precursor,
- optionally pre-heating the exposed precursor,
- developing the exposed precursor by applying first the clean-out solution and then the preservation solution.

8. A method according to claims 6 or 7 wherein the precursor is a photopolymer printing plate precursor.

9. A processor for preparing a printing plate as defined in any of the claims 6 to 8 comprising a clean-out section comprising said clean-out solution and a preservation section comprising said preservation solution in that order **characterized in that** a section of the plate whereupon the preservation solution is applied is conveyed through the preservation section under an angle α with respect to a horizontal direction of less than 0 and greater than or equal to minus 45 degrees.

10. A processor according to claim 9 wherein clean-out solution is applied to the precursor by dip-development and the preservation solution by roller coating.
